# EUROPEAN PATENT APPLICATION

(11) **EP 4 036 966 A1**
(43) Date of publication of application: **03.08.2022**
(21) Application number: 21154772.4
(22) Date of filing: 02.02.2021
(51) Int. Cl.: H01L 23/373, H01L 23/498

(54) **METAL SUBSTRATE STRUCTURE AND METHOD OF MANUFACTURING A METAL SUBSTRATE STRUCTURE FOR A SEMICONDUCTOR POWER MODULE AND SEMICONDUCTOR POWER MODULE**

(71) Applicant: Hitachi Energy Switzerland AG, 5400 Baden (CH)
(72) Inventor: GUILLON, David, 8857 Vorderthal (CH); EHRBAR, Roman, 8037 Zürich (CH); SCHUDERER, Juergen, 8047 Zürich (CH); BEYER, Harald, 5600 Lenzburg (CH)
(74) Representative: Epping - Hermann - Fischer

(57) **Abstract**

A metal substrate structure (10) for a semiconductor power module comprises a metal top layer (11) having at least one penetrating recess (14) which is formed by means of stamping and a metal bottom layer (13). The metal substrate structure (10) further comprises a dielectric layer (12) which is coupled with both the metal top layer (11) and the metal bottom layer (13), wherein the dielectric layer (12) is formed by means of molding between the metal top layer (11) and the metal bottom layer (13).

## Description

The present disclosure is related to a metal substrate structure for a semiconductor power module and a semiconductor power module for a semiconductor device. The present disclosure is further related to a corresponding manufacturing method for a metal substrate structure.

Conventional insulated metal substrates form technology for low and medium power semiconductor packages with low insulation requirements and low thermal resistance simultaneously. In this respect, it is a challenge to provide metal substrates with reliable functionality for high voltage power module applications.

It is desirably to provide a cost saving metal substrate structure for a semiconductor power module that enables reliable functioning even for high voltage power module applications. It is a further object to provide a corresponding semiconductor power module for a semiconductor device and a manufacturing method for such a metal substrate structure.

These objects are achieved by the subject-matter of the independent claims. Further developments and embodiments are described in the dependent claims.

According to an embodiment, a metal substrate structure for a semiconductor power module comprises a metal top layer which has at least one penetrating recess. The metal substrate structure further comprises a metal bottom layer and a dielectric layer which is coupled with both the metal top layer and the metal bottom layer and which is formed by means of molding between the metal top layer and the metal bottom layer.

By use of the described molded metal substrate structure a semiconductor power module is feasible that enables reliable functioning even for high voltage power module applications in a voltage range of 0.5 kV up to 10.0 kV, for example. The described metal substrate structure presents a power module insulated metal substrate including a predetermined metallization structure and a molded insulation layer.

The metallization is formed by the metal top layer which can be a film and/or a sheet comprising copper and/or aluminum. This can also apply to the metal bottom layer which might be formed as a copper and/or aluminum plate. The metal top layer including the recess is formed by means of stamping, for example. In the following description the metal substrate structure is described mostly with respect to a stamped and molded metal substrate and thus might be described in an abbreviated form "SMMS". However, there are alternatives for manufacturing of the top metallization as well. Alternatively or additionally, the metal top layer is formed with a predetermined structure by means of etching and/or laser cutting of a provided metal sheet, for example.

The at least one recess can realize an opening through a coherent piece of metal forming the metallization of the metal top layer. Alternatively, the at least one recess forms a groove or a free volume between two separate metal paths, for example. The metal top layer can also comprise a plurality of recesses and/or grooves to form a predetermined metal pattern to prepare a desired metallization on the top of the SMMS.

The insulation layer in between is realized by the molded dielectric layer. According to an embodiment of the SMMS, the dielectric layer is an epoxy and/or ceramic based dielectric. For example, the molded dielectric layer comprises a resin based dielectric material with ceramic filling material, e.g. epoxy, Al2O3, AlN, BN, Si3N4 or SiO2. For example, the dielectric layer is an epoxy with filler. The dielectric layer can be also based on other materials suitable for transfer, injection or compression molding such as bismaleimide, cyanate ester, polyimide and/or silicones. Alternatively or additionally, the dielectric layer can include a ceramic material and/or hydroset material or a material combination of two or more of the aforementioned components.

It is a recognition in connection with the present disclosure that conventional insulated metal substrates realize technologies for low and medium power semiconductor packages with low insulation requirements and low thermal resistance simultaneously. However, those insulated metal substrates generally comprise dielectric sheet materials which are not suitable for high voltage power module applications. On one side, the insulation capability of currently available dielectric materials is relatively little, resulting in relatively thick needed insulation layers. On the other hand, the thermal conductivity of the dielectric material is not high enough to compensate for thick insulation layers, inhibiting the design and development of thermally efficient high voltage power modules.

Moreover, conventional insulated metal substrates are fabricated usually with pre-preg sheets with two metal plates on top and bottom of an insulation layer. Typically, Cu is used on the topside and either Cu as a bottom plate. The metallization sheets or plates are bonded to the insulation layer by a lamination process. The required metallization structure of the substrate topside is then done by subsequent steps of masking and etching processes to locally remove conductive Cu metal, creating the final metallization structure. Such a fabrication requires a lot of effort and costs and a maximum thickness of the insulation layer is defined by the pre-preg process. Typically, an insulation layer has a thickness of 100 µm with a homogeneous filler distribution. Realizing thicker insulation sheets requires multiple pre-preg layers stacked together.

According to the described SMMS and the molded dielectric layer insulations can be made having a thickness of 50 µm up to 1 mm with respect to a stacking direction from the metal bottom layer towards the metal top layer. Thus, the SMMS can be produced cost saving and with low effort and still enabling beneficial insulation capability as well as thermal conductivity. Relatively thick dielectric layers are useful to contribute to a sufficient insulation capability. The thickness of the molded dielectric still allows for beneficial thermal conductivity and can be manufactured regardless of thickness limitations of today's insulated pre-preg materials.

Moreover, by use of the described SMMS there is no need for a thick and expensive AlN ceramic layer, for example, to securely insulate the high voltage and transfer heat to the cooler of a semiconductor device. In addition, the SMMS enables a beneficial CTE match of the dielectric layer and the coupled top and metal bottom layers, wherein CTE represents the coefficient of thermal expansion. Furthermore, molding of the dielectric layer of the SMMS can be made more accurate than conventional masking and etching with respect to a repeatability of a predetermined thickness and sample to sample variations. With epoxy-based materials of the molded dielectric layer improvement in terms of thermal conductivity and insulation capability are feasible and reduction of necessary material thicknesses and/or reduction of the thermal resistance can be achieved, which both can contribute to thermally beneficial semiconductor power modules. An adjustment of the CTE and improvement of the thermal conductivity can be controlled by use of a resin with filler, for example.

According to an embodiment of the metal substrate structure the dielectric layer is molded such that it extends into at least one recess. For example, the at least one recess is limited by edges of the metal top layer and the dielectric layer is molded such that it covers at least one of the edges. Such edges usually form critical areas for partial discharge due to highest electrical field concentrations. By means of molding the dielectric layer between the metal top layer and the metal bottom layer and into the one or more recesses such critical areas can be covered by the dielectric material of the molded dielectric layer. Thus, the SMMS can contribute to a secure and reliable functioning of a semiconductor power module by toning down the electrical field concentrations. Critical areas of the SMMS are already embedded in the final dielectric layer medium enabling partial discharge testing of raw substrates without an additional insulation medium application.

According to a further embodiment of the metal substrate structure the dielectric layer is molded such that it forms a ditch in at least one recess. Alternatively or additionally in another recess the dielectric layer can be molded such that it forms a barrier extending through the recess protruding above an outer surface of the metal top layer. Such a barrier can be simply formed during the molding of the dielectric layer and can contribute to increase a creepage distance of the semiconductor power module including the SMMS. Accordingly, the barrier can form a protruding part or rib configured to improve creepage behavior. The creepage distance denotes the shortest distance between two conductive objects of the metal top layer along a non-conductive surface.

According to a further embodiment of the metal substrate structure the metal top layer and/or the metal bottom layer are pre-bent. Such a configuration of the SMMS can be useful for certain application. The dielectric layer molded in between the metal top layer and the metal bottom layer will also be formed bowed or bent at the corresponding bent side.

According to a further embodiment of the metal substrate structure the metal top layer comprises a protruding area having a thickness greater than a thickness of an adjacent area of the metal top layer with respect to a stacking direction from the metal bottom layer towards the metal top layer. The metal top layer can comprise two or more protruding areas as well. The thickness of the metal top layer can have a value of 100 µm up to 500 µm or up to 2000 µm. A thinner metal top layer would contribute to lower costs. A thicker metal top layer would contribute to beneficial heat dissipation. If the metal top layer comprises a protruding area, such an area can protrude up to the height of a corresponding semiconductor power module and can have a thickness of 20 mm if it is desired for application, for example.

Moreover, there are further geometrical and material restrictions of the SMMS feasible. The metal top layer, the dielectric layer and the metal bottom layer can comprise a rectangular or square shape and according to the described structure of the SMMS it can be manufactured even with a relatively large side length of 100 mm, 120 mm or 140 mm in x- and/or y-direction, for example. In this respect, the x- and y-directions would correspond to the main plain of extent and the stacking direction would represent the z-direction. Alternatively, the SMMS can also be manufactured having a smaller side length of 34 mm or 20 mm times 30 mm.

The metallization on the top side of the SMMS which realizes the metal top layer can comprise Cu and/or Al. The metallization on the bottom side of the SMMS which realizes the metal bottom layer can comprise Cu and/or Al as well. There are different top side metallization pad thickness, e.g. for USW welding, feasible. Moreover, the SMMS can comprise a pre-bowed backside metallization.

The thickness of dielectric layer is provided controllable by molding process in a value range of 50 µm up to 1000 µm, for example. Additionally, trenches or ribs can be formed between topside metallization pads by means of molding the dielectric layer material. The dielectric layer can be compression molded to the final metal substrate structure in a single compression molding step and no additional masking, etching and cleaning steps are required. This enables to increase degrees of freedom for a semiconductor power module design. Moreover, the described SMMS allows for lower substrate costs and the potential to test yield critical parameters (e.g. partial discharge) prior to chip assembly.

According to an embodiment, a semiconductor power module for a semiconductor device comprises an embodiment of the described metal substrate structure and electronics which is coupled with the metal top layer of the metal substrate structure. The semiconductor power module can further comprise a heat sink which is coupled with the metal bottom layer of the metal substrate structure to dissipate heat during operation of the semiconductor power module. Thus, the semiconductor power module can comprise a separate heat sink. Alternatively or additionally, the metal bottom layer of the metal substrate structure can act as a heat sink itself and can be configured to comprise ribs or protrusion, for example, to provide a beneficial heat dissipation. The metal bottom layer can further act as a baseplate of the semiconductor power module.

Moreover, the semiconductor power module can comprise two or more embodiments of the aforementioned metal substrate structure. The electronics may include chips, integrated circuits and/or other devices discrete devices.

According to an embodiment, a method of manufacturing an embodiment of the described metal substrate structure for a semiconductor power module comprises providing a metal top layer having at least one penetrating recess, which may be done by means of stamping, etching and/or cutting, for example. The method further comprises providing a metal bottom layer, and providing a pumpable substance with predetermined material properties. The pumpable substance is a viscous raw material of the dielectric layer to be formed. Thus, according to an embodiment the pumpable substance is an epoxy and/or ceramic based liquid. Alternatively or additionally, the raw material may comprise inorganic filled for improved thermal conductivity and/or CTE adjustment with respect to the metal top layer and/or the metal bottom layer.

The method further comprises aligning the metal top layer and the metal bottom layer relative to each other with a predetermined distance in between. The distance will substantially predetermine the later thickness of the dielectric layer. For example, the alignment can be realized by placing the metal top layer onto a release film or liner or another fixation, for example in a mold chase of a molding tool. This enables to precisely position the provided metallization structure of the metal top layer relative to the metal bottom layer and can be useful if the metal top layer comprises separate metal pads due to different potentials of operation, for example.

The method further comprises bringing in the provided substance between the aligned metal top layer and the metal bottom layer and thus forming a molded dielectric layer which is coupled with both the metal top layer and the metal bottom layer. The molding can be done by compression molding, transfer molding and/or injection molding, for example. If a release film is used for aligning this can be removed from the top surface of the metallization afterwards.

According to an embodiment of the method the step of bringing in the provided substance comprises providing a cavity at the at least one recess with a predetermined boundary contour, and bringing in the provided substance in the provided cavity and thus forming the molded dielectric layer having a ditch or a barrier extending in the at least one recess. The cavity is formed between the molding tool and the metal top layer and predetermines the later contour of the ditch or the barrier. If there are two or more recesses in the metal top layer, a ditch can be formed in one and a barrier can be in another one. Alternatively, there can be formed two ditches or two barriers as well.

As a result of that the described semiconductor power module and the described manufacturing method comprise or are related to produce an embodiment of the stamped and molded metal substrate structure, described features and characteristics of the SMMS are also disclosed with respect to the semiconductor power module and the manufacturing method and vice versa.

The SMMS realizes a specific substrate design concept for semiconductor power modules which are operable in the range of 0.5 kV up to 10.0 kV insulation capability. The described SMMS can also be used in low or medium voltage ranges. The described SMMS can be based on a stamping, etching and/or cutting process wherein the substrate top side metallization structure is realized prior to the assembly process of the top metallization onto the dielectric layer. The assembly step of connection the metal top layer with the metal bottom layer is molding, which can be done by injection molding, transfer molding and/or compression molding. The molding and forming of the dielectric layer will directly lead to a functional insulated metal substrate without any additional masking and etching processes needed.

The metallization structure of the metal top layer can simply be realized with a mechanical stamping process instead of a time consuming chemical masking, etching and cleaning steps. The stamping process can realize a step included in the corresponding manufacturing method. Alternatively, the stamping process is done at a different location and/or at a different time and the stamped metal top layer is provided with a recess structure. In addition, due to the process of molding the dielectric layer areas where the highest electric field concentrations will occur can directly be covered with the dielectric mold material.

The stamped and compression molded metal substrate structure may enable at least one of the following advantages:
- Less production steps necessary compared to conventional manufacturing processes resulting in lower production costs
- Less metal wastes, stamping residues can be reused
- Stamping process is cheaper compared to conventional masking/etching processes
- Smaller sample to sample variation due to stamping instead of etching
- Higher degree of freedom for substrate design:
   ∘ thickness of insulation dielectric layer can easily be varied, both thinner and thicker compared to conventional limitations to 100 - 200 µm with pre-preg IMS technology
   ∘ thickness of metallization can be thicker (no restrictions due to etching processes),
   ∘ local thickness variation of metallization within one substrate possible
   ∘ thinner and more reproducible insulation distances can be achieved between different potentials on the substrate top side due to higher top metallization edge geometry control with stamping compared to etching
- Critical areas for partial discharge (highest electrical field concentrations) are already in the final dielectric medium enabling partial discharge testing of raw substrates without additional insulation medium application
   - Creepage distance can be achieved or at least enlarged within a mold tool directly with ditches and/or barriers of the mold material
   - No glue is needed for attaching pre-preg to metallization that would reduce the thermal conductivity between metallization and dielectric layer
   - Potential pre-assembly of die or terminal connection is possible before a compression molding step
   - Potential of using a pre-bowed backside plate, which is not feasible by a conventional lamination process

The molding process of forming the dielectric layer between the metal top layer and the metal bottom layer can easily be detected with bleed and mold flash on the edges of metallization patterns. Such a molded epoxy based dielectric layer further comprises a different material than conventional metal substrates.

The present disclosure comprises several aspects, wherein every feature described with respect to one of the aspects is also disclosed herein with respect to the other aspect, even if the respective feature is not explicitly mentioned in the context of the specific aspect.

Exemplary embodiments are explained in the following with the aid of schematic drawings and reference numbers. The figures show:
- Figure 1: embodiment of a semiconductor power module;
- Figures 2-5: embodiments of a metal substrate structure for a semiconductor power module;
- Figure 6: manufacturing process for an embodiment of the metal substrate structure; and
- Figure 7: flow chart for a method of manufacturing an embodiment of the metal substrate structure.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

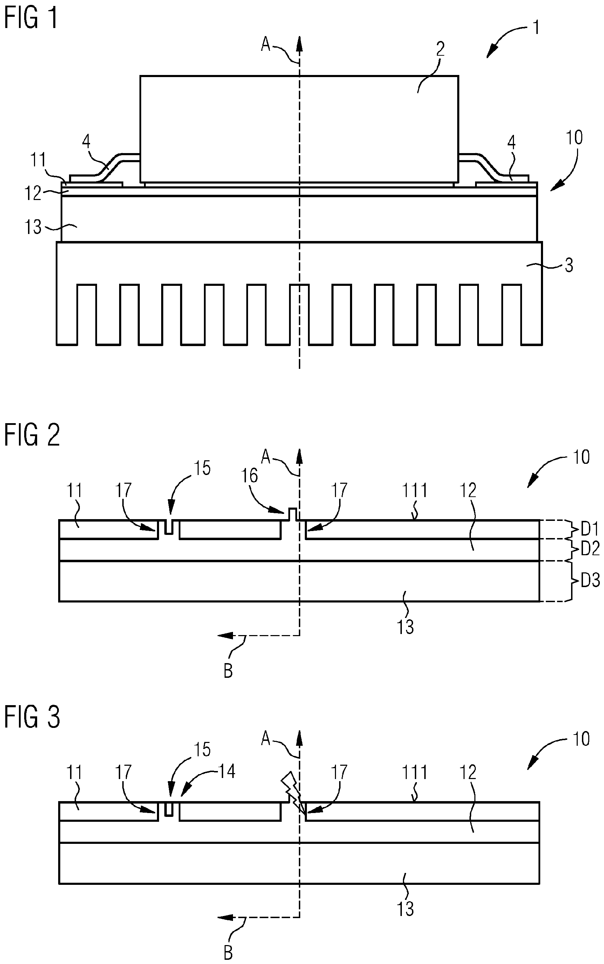

Figure 1 illustrates a side view of an embodiment of a semiconductor power module 1 for a semiconductor device. The semiconductor power module 1 comprises a metal substrate structure 10, electronics 2 which is coupled with the metal substrate structure 10, and a heat sink 3 which is coupled with the metal substrate structure 10 as well. With respect to an illustrated stacking direction A the electronics 2 are coupled with a stamped metal top layer 11 and the heat sink 3 is coupled with a metal bottom layer 13 of the metal substrate structure 10. The metal substrate structure 10 further comprises a molded dielectric layer 12 formed between the metal top layer 11 and the metal bottom layer 13. Due to the stamped and molded elements the metal substrate structure 10 might be described in an abbreviated form "SMMS".

Both, the metal top layer 11 and the metal bottom layer 13 consist of metal or at least comprise metal such as copper and/or aluminum. Alternative thermally and/or electrically conductive materials or material combinations can be used instead. The dielectric layer 12 is an epoxy with filler, for example. The filler can be ceramic like or realized by other inorganic filler. Alternatively or additionally, the dielectric layer 12 comprises a ceramic based insulation layer such as Al2O3, AlN, BN, Si3N4, SiO2. The dielectric layer 12 can also be based on other materials suitable for transfer and compression molding such as bismaleimide, cyanate ester, polyimide and silicones, or might be even based on ceramic materials, such as hydroset materials. Thus, the SMMS 10 realizes an insulated metal substrate with a structured stamped topside metallization, a metal back side plate and a molded dielectric insulation layer in between. Pads of the metal top layer 11 are connected to components of the electronics 2 via leads 4.

The illustrated semiconductor power module 1 can realize a gel-filled power module, wherein the electronics 2 or even the whole top side or even more of the SMMS 10 is embedded in an epoxy and/or gel encapsulation. Such an encapsulation can be done by means of molding afterwards to the manufacturing of the SMMS 10, for example.

The figures 2-5 show embodiments of the SMMS 10 in schematic side views. In figure 2 illustrates the metal substrate structure 10 comprising the stamped metal top layer 11 including two penetrating recesses 14 which are filled with molding of the dielectric layer 12 in a predetermined manner. The dielectric layer 12 is molded such that it extends into the recesses 14, wherein there is a dielectric ditch 15 formed in one recess 14 and a dielectric barrier 16 formed in the other recess 14. The barrier 16 extends through the corresponding recess 14 and protrudes above an outer surface 111 of the metal top layer 11. The protrusion of the barrier 16 can be named as a rib.

The ditch 15 and the barrier 16 are integrally formed with the dielectric layer 12 in one molding process and covers edges 17 of the metal top layer 11 which limit the corresponding recesses 14. The edges 17 are generally critical areas for partial discharge corresponding to highest electrical field concentrations (s. Figure 3 and the illustrated lightning symbol therein). According to the SMMS 10 these areas are already covered by the final medium of the dielectric layer 12. Moreover, partial discharge testing of raw substrates is enabled without an additional insulation medium application. Thus, the highest electrical field concentrations are already embedded within the material of the dielectric layer 12. In addition, a creepage distance within a molding tool can be increased directly with forming the ditch 15 and/or the barrier 16.

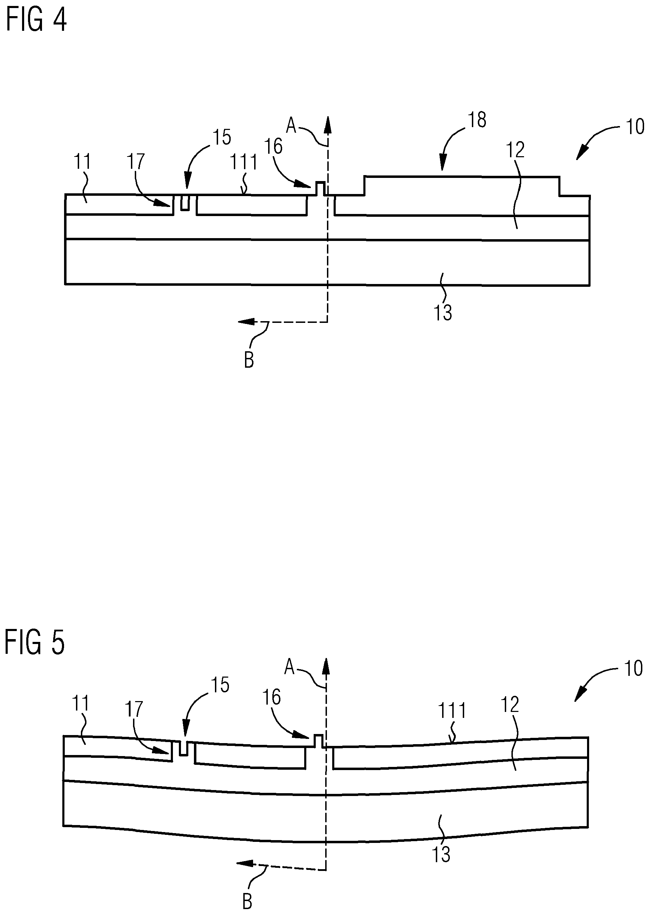

The several layers 11, 12 and 13 of the SMMS 10 comprise respective thicknesses D1, D2 and D3 with respect to the stacking direction A. The metallization metal top layer 11 can comprise the thickness D1 within a value range of 100-500 µm or even up to 2000 µm if an enhanced heat dissipation is desired. Moreover, the metal top layer 11 can comprise different thicknesses as well (s. Figure 4). For example, the metal top layer 11 comprises a protruding area 18 with a thickness of 500 µm wherein a thinner adjacent area of the metal top layer 11 comprises a thickness of 100 µm.

The thickness D2 of the dielectric layer 12 can have a value in the range of 50 µm up to 1000 µm which can be simply predetermined due to a given distance between the metal top layer 11 and the metal bottom layer 13 before molding the dielectric in between.

The thickness D3 of the metal bottom layer 13 can have a predetermined value in order to enable reliable heat dissipation towards the heat sink 3 of the semiconductor power module 1. The metal bottom layer 13 realizes a baseplate of the SMMS 10 and can have a thickness D3 from 0.5 mm to 5.0 mm, for example.

Moreover, with respect to a lateral direction B a width of the recesses 14 and thus a maximum width of the ditch 15 and/or the barrier 16 can be predetermined due to a given stamping tool and corresponding protrusions which forms the edges 17 and the respective sizes of the recesses 14. For instances, a width or a thickness of the ditch 15 or a trench inside the recess 14 can have a relative value of 0.1-0.9 times the distance between the opposite edges 17 limiting the corresponding recess 14, which corresponds to a distance between two adjacent metal pads of the metal top layer 11. A depth of the ditch 15 can equal the thickness D1 of the metal top layer 11. Alternatively, the depth of the ditch 15 can even be larger and including in part the thickness D2 of the dielectric layer 12 additionally.

For instances, a width or a thickness of the barrier 16 or a rib inside the recess 14 can have a relative value of 0.1-1.0 times the distance between the opposite edges 17 limiting the corresponding recess 14. There also can be one or more several ditches/trenches and/or barriers/ribs between metallization pads of the metal top layer 11. The rib of the barrier 16 has a height of 0.1-5.0 mm, for example. Analogously, a depth of the ditch 15 can has a value of 0.1-5.0 mm, for example. The rib and/or the ditch 15 can comprise a rectangular, semi- spherical or triangular shape. Alternatively or additionally, edge regions of top metallization pads of the metal top layer 11 can be specifically overmolded with material of the dielectric layer 12.

According to a further embodiment the SMMS 10 can be formed bent by providing a pre-bent metal top layer 11 and/or metal bottom layer 13 (s. Figure 5). Due to molding the dielectric layer 12 takes the form in the given free volume between the metal top layer 11 and the metal bottom layer 13.

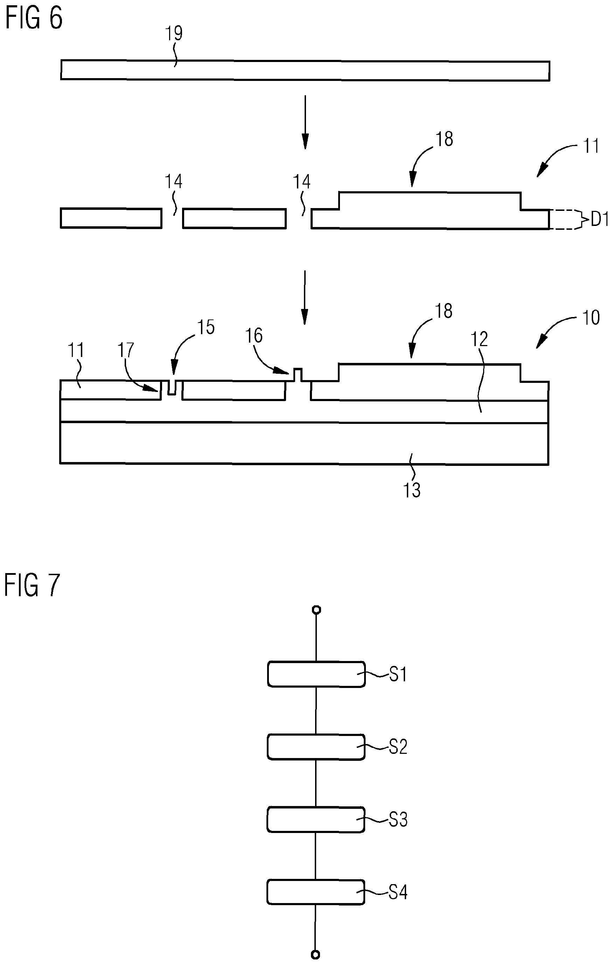

Figure 6 illustrates three manufacturing states to produce an embodiment of the SMMS 10. Steps of a corresponding manufacturing method can follow the flow chart as shown in Figure 7. In a step S1 a raw sheet 19 is provided to form the later metal top layer 11. Moreover, the metal bottom layer 13 can be provided as well as a pumpable substance with predetermined material properties which realizes the liquid or viscous raw material to form the later dielectric layer 12.

In a step S2 the raw sheet is stamped using a stamping tool with protrusions prepared to form recesses 14 and the protruding area 18, for example. Alternatively or additionally, separate metal pads can be stamped out in such a stamping process as well.

In a step S3 the stamped metal top layer 11 and the provided metal bottom layer 13 are aligned relative to each other with a predetermined distance in between. This can be done by using a release film, for example, wherein the provided metallization structure of the metal top layer 11 is assembled onto. Afterwards, such a metal top layer release film unit can be positioned relatively to the provided metal bottom layer 13, for example, wherein the metal top layer 11 faces the metal bottom layer 13.

In a step S4 the provided substance is brought in into the free volume between the aligned metal top layer 11 and the metal bottom layer 13 and thus molding of the dielectric layer 12 is processed. Formation of the dielectric layer 12 can be done by injection molding, transfer molding and/or compression molding and may include the formation of one or more ditches 15 and/or barriers 16 extending in our through corresponding recesses 14. For example, this is done by providing respective cavities limited by the molding tool and the metal top layer 11 in the region of the recesses 14. The provided substance is then brought into such cavities to form a trench, ditch 15, barrier 16 and/or rib.

Thus, an embodiment of the metal substrate structure 10 for the semiconductor power module 1 can be manufactured consisting of a stamped metal plate topside realizing the metal top layer 11, an epoxy based insulation realizing the dielectric layer 12 and a metal plate bottom side realizing the metal bottom layer 13. The metal top layer 11 at least comprises one recess 14 and a top side metallization including several pads. The space between such metal pads can be filled with dielectric material of the dielectric layer 12. The space filling dielectric material is the same insulating material as the one of the dielectric layer 12 between the top and the bottom metallization. According to embodiments, the dielectric layer 12 can be molded and structured with bumps or trenches. The manufacturing of the metal substrate structure 10 can be produced in a single step by molding the stamped top metallization onto the bottom metal plate without any additional masking and etching processes.

Accordingly, a design of the semiconductor power module 1 can comprise one or more of the following:
- Insulating substrate:
   ∘ One large SMMS 10 up to 100 mm, 120 mm or 140 mm side length in lateral direction B (corresponding to x- and/or y-direction)
   ∘ Dielectric mold material with integrated circuit metallization on top side
   ∘ Metal plate with insulating material made of resin filled with inorganic material and circuit metallization
- Chips joined to SMMS 10 by diffusion soldering, sintering or other suitable joining methods like gluing
- Main terminals joined to SMMS 10 by soldering, ultrasonic welding or other suitable joining method
- Auxiliary terminals joined to SMMS 10 by soldering, ultrasonic welding, wire bonding or other suitable joining methods
- Backside metallization:
   ∘ Metal bottom layer 13 of the SMMS 10 made from copper, aluminium or corresponding alloy or composite material
   ∘ Metal bottom layer 13 of the SMMS 10 having flat backside or pre-bowed backside

The realization of the described SMMS 10 and the semiconductor power module 1 for medium to high voltage regime (e.g. 0.5-10.0 kV insulation capability) with a substrate based on a stamped top metallization compression molded onto the dielectric layer 12 and a metal backside plate - all in one step - give rise to several potential product improvements compared to conventional substrate designs. Additionally, to the above mentioned features enable the following advantageous, inter alia:
- Optimization of the thickness D2 of the insulating dielectric layer 12 based on the voltage class and application
- Semiconductor power modules 1 with increased power cycling capability since the CTE (coefficient of thermal expansion) of the compression mold material can be adjusted to Cu/Al of the metal top layer 11 and/or the metal bottom layer 13, reducing CTE mismatches
- With thin dielectric layers 12, SMMS 10 can be realized cost-saving and in larger sizes and requiring less production steps compared to conventional designs that include expensive AlN layers for example, which are challenging in view homogeneous quality

- With a potential pre-assembly of dies and/or terminals prior to a compression molding step, chips and chip assemblies can be pretested and sorted out "individually" or at least in smaller assemblies as a whole power module
- With the highest electric field concentrations within the epoxy material of the dielectric layer 12, the SMMS 10 can be pretested in terms of partial discharge before dies are attached without any special environment such as CO2 and would be comparable to the final partial discharge test of the semiconductor power module 1 (in view of conventional designs, partial discharge is measured on substrate level in a 6 bar CO2 environment "simulating" the future silicone gel) .

The embodiments shown in the Figures 1 to 7 as stated represent exemplary embodiments of the improved metal substrate structure 10, the semiconductor power module 1 and the manufacturing method for; therefore, they do not constitute a complete list of all embodiments. Actual arrangements and methods may vary from the embodiments shown in terms of metal substrate structures and power modules, for example.

### Reference Numerals

- 1: semiconductor power module
- 2: electronics
- 3: heat sink
- 4: leads
- 10: metal substrate
- 11: metal top layer of the metal substrate
- 111: outer surface of the metal top layer
- 12: dielectric layer of the metal substrate
- 13: metal bottom layer of the metal substrate
- 14: stamped recess
- 15: molded ditch
- 16: molded barrier
- 17: metal top layer edge
- 18: protruding area of the metal top layer
- 19: raw sheet

- A: stacking direction
- B: lateral direction
- D1: thickness metal top layer
- D2: thickness dielectric layer
- D3: thickness metal bottom layer
- S(i): steps of a method for manufacturing a metal substrate structure for a semiconductor power module

## Claims

1. A metal substrate structure (10) for a semiconductor power module, comprising:
- a metal top layer (11) having at least one penetrating recess (14),
- a metal bottom layer (13), and
- a dielectric layer (12) which is coupled with both the metal top layer (11) and the metal bottom layer (13) and which is formed by means of molding between the metal top layer (11) and the metal bottom layer (13).

2. The metal substrate structure (10) according to claim 1, wherein the metal top layer (11) including the at least one penetrating recess (14) is formed by means of stamping.

3. The metal substrate structure (10) according to one of the preceding claims, wherein the dielectric layer (12) is an epoxy and/or ceramic based dielectric.

4. The metal substrate structure (10) according to one of the preceding claims, wherein the dielectric layer (12) is molded such that it extends into at least one penetrating recess (14).

5. The metal substrate structure (10) according to one of the preceding claims, wherein the at least one penetrating recess (14) is limited by edges (17) of the metal top layer (11) and the dielectric layer (12) is molded such that it covers at least one of the edges (17).

6. The metal substrate structure (10) according to claim 4 or 5, wherein the dielectric layer (12) is molded such that it forms a ditch (15) in at least one penetrating recess (14) .

7. The metal substrate structure (10) according to claim 4 or 5, wherein the dielectric layer (12) is molded such that it forms a barrier (16) extending through the at least one penetrating recess (14) protruding above an outer surface (111) of the metal top layer (11).

8. The metal substrate structure (10) according to one of the preceding claims, wherein at least one of the metal top layer (11) and the metal bottom layer (13) is pre-bent.

9. The metal substrate structure (10) according to one of the preceding claims, wherein the dielectric layer (12) is molded such that it has a thickness (D2) of 50 µm up to 1000 µm with respect to a stacking direction (A) from the metal bottom layer (13) towards the metal top layer (11).

10. The metal substrate structure (10) according to one of the preceding claims, wherein the metal top layer (11) comprises a protruding area (18) having a thickness greater than a thickness (D1) of an adjacent area of the metal top layer (11) with respect to a stacking direction (A) from the metal bottom layer (13) towards the metal top layer (11).

11. A semiconductor power module (1) for a semiconductor device, comprising:
- a metal substrate structure (10) according to one of the preceding claims, and
- electronics (2) which is coupled with the metal top layer (11) of the metal substrate structure (10).

12. A method of manufacturing a metal substrate structure (10) for a semiconductor power module according to one of the claims 1 to 9, comprising:
- providing a metal top layer (11) having at least one penetrating recess (14),
- providing a metal bottom layer (13),
- providing a pumpable substance,
- aligning the metal top layer (11) and the metal bottom layer (13) relative to each other with a predetermined distance in between, and
- bringing in the provided substance between the aligned metal top layer (11) and the metal bottom layer (13) and thus forming a molded dielectric layer (12) which is coupled with both the metal top layer (11) and the metal bottom layer (13) .

13. The method according to claim 12, wherein the step of bringing in the provided substance comprises:
- providing a cavity at the at least one penetrating recess (14) with a predetermined boundary contour, and
- bringing in the provided substance in the provided cavity and thus forming the molded dielectric layer (12) having a ditch (15) or a barrier (16) extending in the at least one penetrating recess (14).

14. The method according to claim 12 or 13, wherein the metal top layer (11) having at least one penetrating recess (14) is provided by means of stamping.
